# EUROPEAN PATENT SPECIFICATION

(11) **EP 0 266 682 B1**
(45) Date of publication and mention of the grant of the patent: **14.07.1993**
(21) Application number: 87115917.4
(22) Date of filing: 29.10.1987
(51) Int. Cl.: H03M 1/60, G01J 3/42

(54) **Spectrophotometer with line frequency slaved voltage-to-frequency converter system**
Spectrophotometer mit Netzfrequenzgesteuertem Spannungsfrequenzumsetzersystem
Spectrophotomètre avec système de conversion de tension en fréquence asservi à la fréquence du réseau

(30) Priority: 07.11.1986 US 927991
(43) Date of publication of application: 11.05.1988
(73) Proprietor: THE PERKIN-ELMER CORPORATION, Norwalk Connecticut 06856-0181 (US)
(72) Inventor: Wittmer, Charles M., Trumbull Connecticut (US)
(74) Representative: Grünecker, Kinkeldey, Stockmair & Schwanhäusser Anwaltssozietät

(56) References cited:
- GB-A- 1 143 253
- GB-A- 1 580 530
- US-A- 3 500 196
- US-A- 4 201 472
- US-A- 4 380 757
- W.F. WALLER: "Digital Instruments", 1968, pages 22-33, Product Journals, West Wickham, Kent, GB; J.R. PEARCE et al.: "Digital voltmeters"

## Description

### Background of the Invention

This invention relates to a spectrophotometer system. In particular, to a spectrophotometer system having a spectrophotometer providing an analog sample signal, amplifier means for amplifying the analog signal and analog-to-digital conversion means for converting the analog sample signal to an output digital signal wherein the analog-to-digital conversion means comprises a synchronous voltage-to-frequency converter connected to receive the analog input signal voltage and to generate a train of output pulses, a counter connected to receive and count the output pulses from the synchronous voltage-to-frequency converter a digital register connected to the counter for periodically receiving and storing the count in the counter. Spectrophotometer systems of the specified form are known from U.S. Patent No. 4,201,472.

In precision instrumentation, and particularly in electro-optical precision instrumentation, and especially in spectrophotometers which may be used for purposes such as optical chemical analysis, it is extremely important to avoid or eliminate noise interference signals from electrical measurement signals. Some of the most persistent and serious sources of such noise and interference are related to the alternating current power supply. For instance, ambient room illumination from gaseous discharge lamps such as fluorescent lamps varies substantially in response to the alternations of the power frequency. Similarly, the fluctuations in the voltage of the power supply to the spectrophotometer cannot be completely filtered out, and may appear in the output signal. Also, ambient acoustic signals which are power frequency related can arise from electrical apparatus which is in operation near the spectrophotometer, and which can create minute mechanical movements of optical components which give rise to further power frequency related noise. Analog to Digital conversion (with power line frequency noise reduction is, for instance, disclosed in one British Patent GB-A-1,143,253. There, transient frequency variations are eliminated by using an average cycle length.

Accordingly, it is an important object of the present invention to provide a spectrophotometer having an analog-to digital converter system which eliminates power line frequency related noise and interference signals from an analog voltage signal as converted to a digital signal.

It is known that power line frequency noise signals can be eliminated by selecting a conversion interval for an analog-to-digital converter which corresponds to the cycle interval of the power line or to exact multiples of that interval. Accordingly, the selection of conversion intervals corresponding to the power line cycle interval is advocated. However, different power line frequencies are employed such as 50 cycles as well as 60 cycles. Furthermore, the frequency of the power line may be intentionally or unintentionally varied from a strictly regulated 60 cycle or 50 cycle frequency. For instance, in some communities in the world it is common to increase the power line frequency after a power shutdown in order to readjust the customer's clocks. In other systems, such as small independent power systems, the frequency of the power system is not carefully regulated. Accordingly, it is not possible to achieve complete and reliable power line frequency related noise elimination from the signal being processed by simply determining the conversion interval as a fixed interval corresponding to the nominal power line cycle interval.

Accordingly, it is another important object of the present invention to provide a spectrophotometer having an analog-to-digital converter system which will automatically eliminate power line related noise from the signal being converted no matter what the power line frequency may vary.

Further objects and advantages of the invention will be apparent from the following description and the accompanying drawings.

According to the invention, the above objects are solved with an apparatus as defined in the preamble of claim 1 having the features of the characterizing part.

### Summary of the Invention

In carrying out the invention, there is provided a system for precision conversion of an analog input signal represented by a voltage to an output digital signal represented by a number comprising a voltage-to-frequency converter connected to receive the analog input signal voltage and to generate a train of output pulses, a counter connected to receive and count the output pulses from said voltage-to-frequency converter, a digital register connected to said counter for periodically receiving and storing the count in said counter, a conversion interval timer circuit connected to control the operation of said counter and said register to determine a conversion interval during which the output pulses from said synchronous voltage-to-frequency converter are accumulated in said counter and then stored in said register, said conversion interval timer circuit being connected and arranged to receive ac power line voltage and being operable to determine the end of a prior conversion interval and the beginning of a new conversion interval in response to a predetermined phase of a predetermined cycle of the ac power line voltage, means for receiving and correcting the number from said register comprising means for exact measurement of the duration of each conversion interval and means for multiplying the number stored in said register by a function which is a reciprocal of the exact duration measurement from said exact measurement means to thereby correct the number for variations in the conversion interval.

In a preferred embodiment, the invention also includes a programmable gain amplifier which makes the analog-to-digital converter extremely sensitive over a wide signal range, essentially increasing the range of the amplifier by a ratio of one hundred to one.

In accordance with another feature of a preferred embodiment of the invention, the cost of the analog-to-digital converter incorporated in the analog-to-digital conversion system is greatly reduced, and the accuracy is improved, by employing a synchronous analog-to-digital converter circuit.

### Brief Description of the Drawings

Fig. 1 is a schematic circuit diagram of a preferred apparatus for carrying out the invention.

Fig. 2 is a timing diagram illustrating the various timing pulses which are present in the system of Fig. 1., and which particularly illustrate the slaving of the system to the power frequency cycle interval.

### Description of Preferred Embodiments

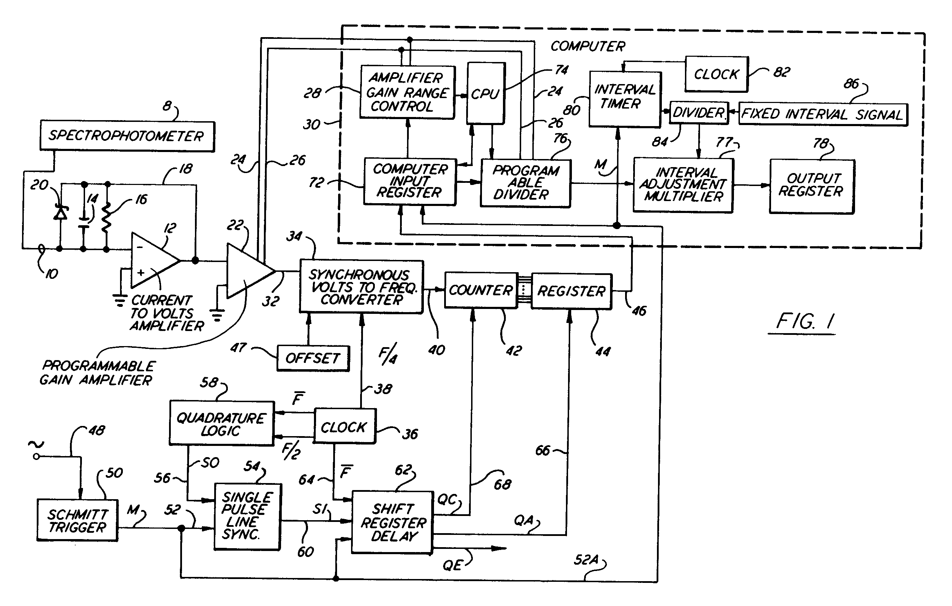

Referring more particularly to Fig. 1, there is shown a schematic circuit diagram of a preferred embodiment of an apparatus for carrying out the invention. The system includes an input terminal 10 for receiving the analog input signal which is to be converted to a digital signal output. The input signal to terminal 10 is typically obtained from a precision measuring instrument such as a spectrophotometer 8. The signal from terminal 10 is applied to a preamplifier 12, which is preferably a field effect transistor operational amplifier connected in a "current-to-voltage" configuration. A voltage-to-voltage configuration could also be used for preamplifier 12. The capacitor 14 and the resistor 16 connected in the feedback loop 18 form a first order low-pass filter at approximately 30 hertz to reduce any spurious noise in the input signal. The zener diode 20, which is also connected in the feedback circuit 18, limits the output voltage of the amplifier at a nominal 12 volts. The system is not designed to respond to input voltages above 10 volts, and the zener diode 20 provides for overload protection, and for faster recovery from overload conditions.

If desired, the output of the preamplifier 12 can be connected to a separate amplifier (not shown) to drive an analog signal recorder. However, that feature does not constitute a part of the present invention.

The output from the preamplifier 12 is connected to the input of an amplifier 22, which is a programmable gain amplifier. The gain of amplifier 22 is controllable through input connections 24 and 26 from an amplifier gain range control circuit 28 which comprises part of a digitial computer 30. The programmable gain amplifier 22 is changeable in range in ten to one steps to provide a total range change ratio of one hundred to one to accommodate for different input signal voltages. Binary, or other gain change ratios can also be used. The mode of control for the changes in range is described more fully below. Programmable gain amplifiers of the above description are commonly available. One commercially available device of this type which has been found to be satisfactory in the present circuit is an amplifier device model number PGA102 available from Burr-Brown Corporation, P.O. Box 11400, Tucson, AZ 85734.

The output signal from the programmable gain amplifier 22 is carried through connection 32 to a voltage-to-frequency converter 34. The voltage-to-frequency converter 34 is preferably carried out as a synchronous voltage-to-frequency converter, which means that the frequency converter operates under the control of a clock circuit 36 through a control connection 38 to provide output pulses at the output connection 40 which occur only at timed intervals. If the input voltage is below the maximum input, output pulses are omitted at some of the timed intervals. The number of pulses delivered over a given period provide the digitial output. Such voltage-to-frequency converters are commercially available. For instance, one satisfactory converter is product number AD651 available from Analog Devices of 2 Technology Way, Norwood, Massachusetts 02062-9106. Another satisfactory converter is available under model number VFC100 from Burr-Brown. Since these devices are known, they are not described in detail here. However, in general terms, the synchronous voltage-to-frequency converter 34 includes an integrator circuit at the input, a comparator circuit which compares the output of the integrator circuit with a constant reference voltage, and a clock logic circuit which provides a clocked output pulse, as determined by the clock 36, and resets the integrator circuit upon the occurence of each clock pulse which occurs after the comparator circuit indicates that the integrator output has progressed beyond the reference voltage. The reset of the integrator circuit results in clocked output pulses which occur at an average rate corresponding to the input voltage. The output pulses are carried by the connection 40 to a counter 42 where the count is accumulated for a conversion interval, and that count is then transferred to a digital register 44 where it is available through a connection schematically indicated at 46 to the computer 30. A fixed positive offset signal is preferably applied to the converter 34 by an offset circuit 47 to assure that the converter 34 is always in the active operating range. A number corresponding to this offset is stored in computer 30 and is subtracted from each measurement stored in computer register 72 to compensate for the offset.

In accordance with an important feature of the present invention, the conversion interval during which the counter 42 accumulates the counts from the converter 34 is exactly synchronized with the period of one cycle of the power on the local power line. The power line frequency is applied at terminal 48, shown in the lower left corner of the drawing, and through that terminal to a Schmitt trigger circuit 50, which converts the power line input to a square wave signal which is designated M. That signal is applied, as shown, to an input connection 52 of a single pulse line synchronization circuit 54. The single pulse line synchronization circuit 54 is also provided with a clock signal S0 through a connection 56. The clock signal S0 is derived from the clock circuit 36 through a quadrature logic circuit 58. The single pulse line synchronization circuit 54 is designed so that upon the first clock synchronization pulse S0 following the leading edge of a power frequency derived pulse M, a single pulse output S1 is provided at connection 60. That single pulse is provided to a shift register delay circuit 62, which is then operable under the control of the clock 36 through a connection 64 to provide a sequence of control pulses QA and QC on the output connections 66 and 68. The QA pulse on connection 66 is connected to control the register 44 to read the count data stored in the counter 42, which marks the end of the conversion interval. Immediately subsequent to that operation, the QC pulse appears on connection 68 to reset the counter 42 to begin a new conversion interval. At about the same time, the M signal is supplied from the Schmitt trigger 50 through a connection 52A to the computer 30 as a "data ready" signal, telling the computer that it can read the data available from register 44 on connection 46.

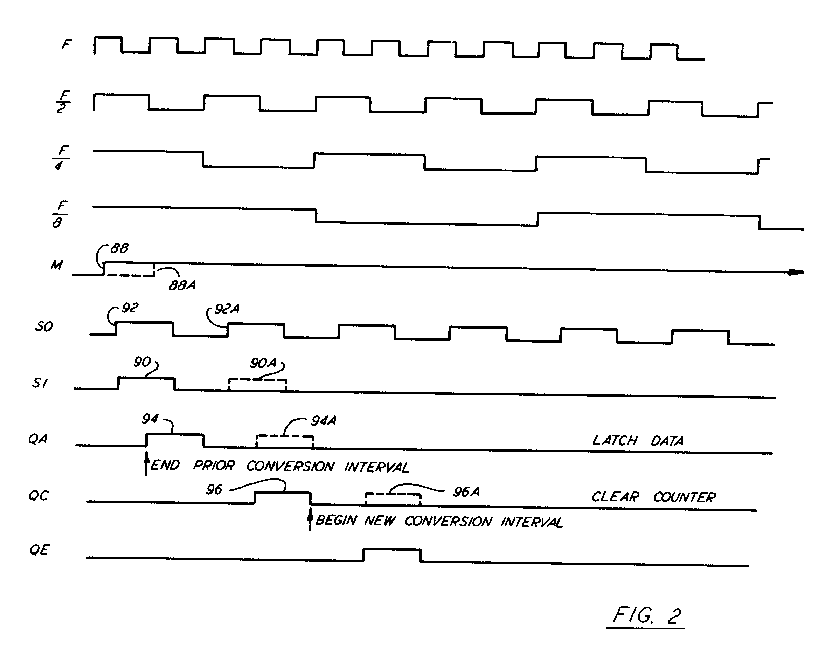

Strictly speaking, the data is not actually ready until after the QA pulse on connection 66 causes the register 44 to read the contents of the counter 42. Since the control pulse QA occurs slightly after the beginning of the M pulse, the M pulse "data ready" signal on connection 52A to the computer is slightly early. However, the computer is programmed to always respond with some delay to the data ready signal. Thus, the data in the register 44 which is read by the computer is the latest data which has been read from the counter under the control of the QA pulse. If this is a problem, however, the data ready signal can be provided from a QE output from the shift register delay circuit 62 which occurs after the QA and QC outputs. The timing of the operation of the circuits which provide the sample interval control signals QA, QC, and M will be better understood by reference to Fig. 2, and the explanation of Fig. 2 which appears below.

Referring further to Fig. 1, in addition to the amplifier range control circuit 28, the computer 30 may include a computer input register 72, a central processing unit 74, a programmable divider 76, and an output register 78. The computer input register 72 receives the accumulated count values from the register 44 through connection 46 when the data ready signal is available on connection 52A. The amplifier gain range control 28 and the programmable divider 76 each receive the counts stored in the computer input register 72. The amplifier range control controls the amplification range of the amplifier 22 based upon the count present in the computer input register 72 from the prior conversion interval. The programmable divider 76 is also operable under the control of the gain range control 28 to divide the output from the register 72 by the amplification ratio to compensate for amplifier gain range control settings, and the divided output is supplied through an interval adjustment multiplier 77 to the output register 78. The inverval adjustment multiplier 77 adjusts the count from the sample interval to automatically adjust for variations in the frequency interval of the power source. The power source interval is measured by an interval time 80 to time the interval between successive power line synchronization signal pulses M. The interval timer 80 operated under the control of a computer clock 82.

It is one of the most important features of the present invention that the system can accommodate for fluctuation in the power frequency. The apparatus such as the spectrophotometer 8, of which the present invention may form a part, may sometimes be used under conditions where the power frequency is not controlled with great precision, or in which the power frequency may be intentionally altered in order to correct synchronous electric clocks after a power interruption. Accordingly, the present system synchronizes with the power frequency interval, no matter what that frequency may be, and the interval timer 80 controls the interval adjustment multiplier 77 to appropriately correct the count taken during the sample interval to compensate for variations in the power frequency interval.

This feature can not only automatically adjust the operation of the system for minor frequency fluctuations, but can also automatically adjust for intentional changes to other power frequencies such as 50 hertz.

The most important advantage of the exact synchronization of the operation of the converter system with the interval of the power frequency is that it provides for automatic rejection of line frequency noise signal components. This is extremely important in very sensitive apparatus such as spectrophotometers, for which the present invention is intended to be used. The rejection of line frequency "noise" is effective with respect to electrical signal noise components and also with respect to acoustic noise, and illumination noise signals which are related to the line frequency.

The interval timer 80 operates to control the interval adjustment multiplier 77 through a divider circuit 84 in conjunction with a fixed interval signal from a fixed interval signal circuit 86. The fixed interval signal from circuit 86 is simply a fixed number, and the divide circuit 84 divides that fixed number by the digital number from the interval timer 80 signifying the duration of the last interval. The result of that division is then used as a multiplication factor in the interval adjustment multiplier 77. Thus, it may be said that the combination of the interval timer and the divide circuit 84 and the fixed interval circuit 86 causes the interval adjustment multiplier 77 to multiply the measurement by a reciprocal function of the time interval measured by the interval timer 80. The result is stored in the output register 78.

Another important advantage of the circuit and system as just described, and particularly of the feature which corrects the counts taken during the conversion interval to conform with a fixed interval signal is that the system corrects for any errors arising from changes in the frequency signals available from the clock 36. Such changes in the clock frequency may arise from drift with time or temperature, for instance. It is assumed, first, that the clock 82 of the computer 30 is very accurate, and will provide a "fixed" standard by which the operation of the voltage-to-frequency converter system may be adjusted through the interval adjustment multiplier 77.

The computer 30 has been presented as incorporating a number of special function circuits and components such as the amplifier gain range control 28, the programmable divider 76, the interval timer 80, etc. The invention may be implemented with a special purpose computer which contains all of these special purpose components. However, it will be understood that the functions may also be performed by means of a general purpose computer which is programmed to carry out all of the functions described in conjunction with the special purpose components, and those programmed functions may be typically carried out on a time-sharing basis by the general purpose computer, which may be a microcomputer.

Fig. 2 is a timing diagram which further exemplifies the operation of the clock 36, the quadrature logic 58, the Schmitt trigger 50, the single pulse line synchronization circuit 54, and the shift register delay 62. The clock 36 includes a crystal oscillator which is designed to produce a square wave output F as illustrated at the top of the timing diagram Fig. 2. The frequency of that output in the preferred embodiment may be, for instance, 8 megahertz.

The clock circuit 36 is also capable of delivering a phase reversed square wave clock signal shown in the drawing by the symbol F̅. The phase reversal F signal is not illustrated in the timing diagram of Fig. 2. The clock circuit 36 is also capable of providing clock pulses at one half the frequency of F and at one quarter of the frequency of F. Those signals are shown in the drawing and are designated as F/2 and F/4 respectively. The F/4 pulses are supplied to the synchronous voltage-to-frequency converter 34 on connection 38, and are used as the basic clock for that circuit.The resultant output signals from converter 34 are at a maximum frequency of one half the F/4 frequency and identified as F/8 in Fig. 2. If a maximum voltage is supplied at input 32 to the synchronous voltage-to-frequency converter 34, then an output pulse appears at the output 40 for every F/8 cycle. However, for any lesser voltage, output pulses are skipped, to give a lower total pulse count in a conversion interval. In the preferred embodiment, the maximum output pulse frequency is about one megahertz.

The power line synchronization signal M, which appears as the output from the Schmitt trigger 50, is not synchronized with the clock 36, and a rising edge of a typical pulse will occur, as indicated at 88 in the M curve of the timing diagram of Fig. 2, at a time which is unrelated to the clock pulses.

The quadrature logic circuit 58 receives the phase reversal F clock signal and the F/2 clock signal from clock circuit 36, and in response to those signals generates a pulse train S0 which appears at the connection 56. The pulses of that pulse train are delayed, as shown, by one half of the interval of the F frequency curve, and appear at a frequency of F/2. As previously mentioned above, upon the first occurrence of a rising edge 92 of the S0 curve after the rising edge 88 of the power frequency synchronization pulse M, the single pulse line synchronization circuit 54 generates a signal pulse S1. That pulse S1 is illustrated at 90 in the curve S1. Describing the operation of the single pulse line synchronization circuit 54 another way, after the rising edge 88 of the line synchronization signal M, the first rising edge 92 of the S0 signal causes the single pulse line synchronization circuit 54 to emit the single pulse 90 of curve S1. In response to that signal, the shift register delay circuit 62 generates a series of timing pulses as shown at curves QA and QC in Fig. 2. The QA pulse is shown at 94, and the QC pulse at 96. A QE pulse output is also available, which occurs after the QC pulse, as illustrated in the timing diagram.

The leading edge of the QA pulse 94 ends the prior conversion interval by enabling the register 44 through connection 66 to read the contents of the counter 42, as previously described. Also, as previously mentioned above, the QC pulse 96 is supplied through connection 68 to the counter 42 to reset that counter to zero to thus begin a new conversion period. Thus, the new conversion period begins at the trailing edge of the pulse 96.

If the wave front of the power frequency timing signal M arrives after the S0 wave front at 92, such as indicated by the dotted line at 88A, then the single pulse line synchronization circuit 54 is not actuated until the next rising wave front 92A of pulse train S0 as shown in Fig. 2. The result is that the single pulse S1 is issued at 90A (shown dotted) in coincidence with pulse 92A, and the QA and QC pulses are delayed as shown dotted respectively at 94A and 96A. If the M wave front occurs earlier, it may precede an earlier S0 wave front, causing an earlier emission of QA and QC pulses. This illustrates how the system is synchronized with the power frequency interval signal M.

The above description of the synchronization or slaving of the system to the power frequency interval is presented entirely in terms of a single power frequency interval, having the conversion interval corresponding exactly to a single power frequency cycle interval. However, it is also possible to achieve the desired discrimination by selecting a conversion interval which is a fixed and predetermined whole multiple of the power frequency cycle interval. Thus, for instance, the end of a prior conversion interval and the beginning of a new conversion interval may be determined in response to a predetermined phase of every third cycle of the ac power line voltage. However, it is not necessary to use the longer interval to get a larger sample because it is simple to combine the readings from several conversion intervals to provide greater accuracy as described more fully below.

Referring back again to Fig. 1, the synchronous voltage-to-frequency converter 34, by its nature, has a fixed upper limit of response corresponding to a full count in which an output pulse is provided for every F/8 cycle. With the preferred synchronous voltage-to-frequency converter 34, this occurs at an input voltage of about ten volts. This maximum frequency output from the converter 34 can be recognized in terms of a maximum number count at the computer input register 72 by the amplifier gain range control 28. When this maximum count number is achieved, the amplifier gain range control 28 reduces the amplification factor by changing the setting of the programmable gain amplifier 22 by a signal on one of the lines 24 or 26 (unless the amplifier 22 is already set to the lowest gain). The reduction in amplification is preferably by a ratio of ten to one, to put the converter 34 back into a range where a meaningful measurement can be taken. At the same time, the amplifier gain range control modifies the operation of the programmable divider 76 to reduce the division factor of that circuit by a ratio of ten to one to correct for the lower range in the measurement number ultimately supplied to the output register 78. If the upper limit on the converter 34 is again exceeded, resulting in the maximum output, the amplification factor of the programmable amplifier 22 is again reduced by a ratio of ten to one, (unless the amplifier is already at the lowest amplification setting) and the programmable divider ratio is also again reduced by a ratio of ten to one. The amplifier gain range control 28 may be programmed to respond exactly to the maximum output from the converter 34, or it may be programmed to respond to a number which is near the maximum output count for the conversion interval.

If the input voltage is reduced so that the count from the converter is at a selected value somewhat less than ten percent of the maximum, the amplifier gain range control 28 is operable to increase the amplification factor by a ratio of ten to one, and to increase the division factor of divider 76 by a ratio of ten to one (unless the amplification factor is already at the maximum value). Thus, the amplifier gain range control automatically adjusts the programmable gain amplifier 22 and the programmable divider 76 to provide for a very high degree of accuracy, which provides one hundred times as much resolution as would be provided without the programmable gain amplifier and the associated system just described.

The precision of the system may be greatly enhanced by taking a series of measurements over a successive series of conversion intervals and averaging those measurements. For instance, thirty conversion intervals may be taken and averaged in order to provide high precision, and the total measuring time for the thirty conversion intervals is only half a second at sixty cycles.

In reviewing the timing of the system, as illustrated by the timing diagram of Fig. 2, it is quite clear that the entire power frequency synchronization sequence, as represented by the curves M, S0, S1, QA, and QC occurs in less than one microsecond, and one microsecond is the interval of the one megahertz frequency which is the highest output frequency available from the synchronous voltage-to-frequency converter 34. Accordingly, in normal operation, no output pulses from the synchronous voltage-to-frequency converter 34 are lost because a new conversion interval is commenced as soon as a prior conversion interval is ended.

At 60 cycles, the maximum number of pulses available in the conversion interval at one megahertz is 16,667 (rounding to the nearest whole number). Since the programmable gain amplifier 22, and the programmable divider 76, provide a multiplication of the resolution of the system by a factor of one hundred, the resolution is actually over a million, being in the order of 1,666,667.

While this invention has been shown and described in connection with particular preferred embodiments, various alterations and modifications will occur to those skilled in the art. Accordingly, the following claims are intended to define the valid scope of this invention.

## Claims

1. A spectrophotometer system having a spectrophotometer (8) providing an analog sample signal, amplifier means (12,22) for amplifying the analog signal and analog-to-digital conversion means for converting the analog sample signal to an output digital signal wherein the analog-to-digital conversion means comprises:
a synchronous voltage-to-frequency converter (34) connected to receive the analog input signal voltage and to generate a train of output pulses,
a counter (42) connected to receive and count the output pulses from said synchronous voltage-to-frequency converter (34),
a digital register (44) connected to said counter (42) for periodically receiving and storing the count in said counter (42), **characterised in that** said analog-to-digital conversion means further comprises
a conversion interval timer circuit means connected to control the operation of said counter (42) and said register (44) to determine a conversion interval during which the output pulses from said synchronous voltage-to-frequency converter (34) are accumulated in said counter (42) and then stored in said register (44),
said conversion interval timer circuit means being connected and arranged to receive ac power line voltage and being operable to determine the end of a prior conversion interval and the beginning of a new conversion interval in response to a predetermined phase of a predetermined cycle of the ac power line voltage to exactly synchronise the conversion interval to the ac power line frequency, and
said conversion interval timer circuit means being configured and connected to said synchronous voltage-to-frequency converter (34) so as to control the generation of output pulses so that output pulses are generated only during a conversion interval.

2. The system of claim 1 wherein the predetermined cycle for determining the end of a prior conversion interval and the beginning of a new conversion interval is every cycle.

3. The system of claim 1 wherein the predetermined cycle for determining the end of a prior conversion interval and the beginning of a new conversion interval is separated from the prior predetermined cycle by at least two whole power frequency intervals.

4. The system of claim 1 comprising
means (30) for receiving and correcting the number from said register (44) comprising
means (80) for exact measurement of the duration of each conversion interval and
means (77) for multiplying the number stored in said register by a function which is a reciprocal of the exact duration measurement from said exact measurement means (80) to thereby correct the number for variations in the conversion interval.

5. The system of claim 1 wherein said timer circuit means comprises a clock means (36) connected to said synchronous converter (34) for controlling the operation of said synchronous converter (34), said timer circuit means being operable to determine the end of a prior conversion interval and the beginning of a new conversion interval in synchronism with said clock means (36) at clock synchronized times after said predetermined phase of the ac power line voltage.

6. The system of claim 5 wherein said clock means (36) provides clock pulse signals to said synchronous converter (34) at a frequency of F/4 so that the maximum frequency output of said synchronous converter is F/8 and the intervening interval between the end of the prior interval and the beginning of a new conversion interval is synchronized to a multiple frequency of said clock means (36) such that the output pulses from said converter means (34) are generated outside said intervening interval.

7. The system of claim 5 wherein said timer circuit means comprises a single-pulse line synchronization circuit (54) operable to receive clock pulse signals from said clock means (36) at a frequency which is a multiple of the maximum output frequency of said synchronous voltage-to-frequency converter (34) and operable to receive an ac line synchronization signal, said single-pulse line synchronization circuit (54) being operable upon the receipt of the first clock pulse signal after the presence of an ac line synchronization signal to issue a single pulse output, a shift register delay circuit (62) connected to receive said single-pulse output and operable in response thereto to emit a sequence of at least two pulses respectively to said register (44) to cause said register (44) to read the count in said counter (42) and to said counter (42) to reset said counter (42) to begin a new conversion interval.

8. The system of claim 7 wherein said clock means (36) generates clock pulse signals in multiples of a predetermined frequency F, said clock means (36) providing clock pulse signals to said synchronous converter (34) at a frequency F/4 such that the maximum output frequency of said synchronous converter (34) is F/8, and said clock pulse signals received by said single-pulse line synchronization circuit (54) from said clock means (36) being at a frequency of F/2.

9. The system of claim 8 which comprises quadrature logic circuit means (58) interconnecting said clock means (36) and said single-pulse line synchronization circuit means (54) for providing clock pulse signals to said synchronization circuit means (54) at a frequency F/2 and delayed by 1/2 of the interval of the F frequency curve.

10. The system of claim 5 wherein a programmable gain amplifier (22) is connected to receive and amplify the analog input signal prior to delivery of said analog input signal to said synchronous voltage-to-frequency converter (34), an amplifier gain range control means (28) connected and operable to receive the successive numbers stored in said register (44) and connected to control said programmable amplifier (22), said amplifier gain range control means (28) being operable in response to the detection of a number from said register (44) indicating that said synchronous voltage-to-frequency converter (34) is running at maximum frequency to reduce the amplification factor of said programmable amplifier (22), said amplifier gain range control means (28) being operable upon the detection of a number below a predetermined minimum value to increase the amplification factor of said programmable amplifier (22), and said amplifier gain range control means (28) including means (76) operable to divide the output from said register (44) by said amplification factor to provide an accurately scaled digital output signal.

11. The system of claim 10 wherein said programmable amplifier (22) is operable to change the amplification factor in response to range control signals over a range of one hundred to one in two steps of ten to one, and wherein said amplifier gain range control means (28) comprises a part of a general purpose computer (30) which is programmed to accomplish the amplifier gain range control function.

12. The system of claim 1 which comprises an overload limit circuit (20) and a low-pass filter (14,16) for protecting the remainder of the system from overload voltage conditions.

## Patentansprüche

1. Ein Spektrophotometersystem mit einem ein analoges Probensignal schaffendes Spektrophotometer (8), Verstärkervorrichtungen zum Verstärken des analogen Signals und Analog-zu-digital-Umwandlungsvorrichtungen zum Umwandeln des analogen Probensignals in ein digitales Ausgabesignal, wobei die Analog-zu-digital-Umwandlungsvorrichtungen umfassen:
einen synchronen Spannung-zu-Frequenz-Umwandler (34), der so angeordnet ist, daß er die analoge Eingabesignalspannung empfängt und einen Zug von Ausgabepulsen erzeugt,
einen Zähler (42), der so angeordnet ist, daß er die Ausgabepulse von dem synchronen Spannung-zu-Frequenz-Umwandler (34) empfängt und zählt,
ein digitales Register (44), das mit dem Zähler (42) verbunden ist, um periodisch den Zählwert in dem Zähler zu empfangen und abzuspeichern, **dadurch gekennzeichnet,** daß die Analog-zu-digital-Umwandlungsvorrichtungen weiter umfassen:
eine Umwandlungsintervallzeitschaltkreisvorrichtung, die so angeordnet ist, daß sie den Betrieb des Zählers (42) und des Registers (44) steuert, um ein Umwandlungsintervall zu bestimmen, währenddem die Ausgabepulse von dem synchronen Spannung-zu-Frequenz-Umwandler (34) in dem Zähler (42) gesammelt werden und dann in dem Register (44) abgespeichert werden, wobei die Umwandlungsintervallzeitschaltkreisvorrichtung so geschaltet und angeordnet ist, daß sie die Netzwechselspannung empfängt und in der Lage ist, das Ende eines vorhergehenden Umwandlungsintervalls und den Beginn eines neuen Umwandlungsintervalls zu bestimmen in Erwiderung auf eine vorbestimmte Phase eines vorbestimmten Zyklus der Netzwechselspannung, um genau das Umwandlungsintervall mit der Netzwechselspannung zu synchronisieren, und
daß die Umwandlungsintervallzeitschaltkreisvorrichtung so ausgestaltet und mit dem synchronen Spannung-zu-Frequenz-Umwandler (34) verbunden ist, daß sie die Erzeugung von Ausgabepulsen steuert, so daß die Ausgabepulse nur während eines Umwandlungsintervalls erzeugt werden.

2. Das System gemäß Anspruch 1, wobei jeder Zyklus ein vorbestimmter Zyklus zum Bestimmen des Endes eines vorhergegangenen Umwandlungsintervalls und des Beginns eines neuen Umwandlungsintervalls ist.

3. Das System nach Anspruch 1, wobei der vorbestimmte Zyklus zum Bestimmen des Endes eines vorhergegangenen Umwandlungsintervalls und des Beginns eines neuen Umwandlungsintervalls von dem vorhergegangenen vorbestimmten Zyklus um mindestens zwei ganze Netzfrequenzintervalle getrennt ist.

4. Das System nach Anspruch 1, das weiter umfaßt:
Vorrichtungen (30) zum Empfangen und Berichtigen der Zähl aus dem Register (44),
Vorrichtungen (80) zum genauen Messen der Dauer eines jeden Umwandlungsintervalls und
Vorrichtungen (77) zum Multiplizieren der in dem Register gespeicherten Zahl mit einer Funktion, welche ein umgekehrter Wert des genauen Meßwerts der Dauer von der genauen Meßvorrichtung (80) ist, um dadurch die Zahl von Veränderungen in dem Umwandlungsintervall zu berichtigen.

5. Das System nach Anspruch 1, wobei die Zeitschaltkreisvorrichtung eine Taktgebervorrichtung (36) umfaßt, die mit dem synchronen Umwandler (34) verbunden ist, um den Betrieb des synchronen Umwandlers (34) zu steuern, wobei die Zeitschaltkreisvorrichtung erlaubt, das Ende eines vorhergegangenen Umwandlungsintervalls und den Beginn eines neuen Umwandlungsintervalls synchron mit der Taktvorrichtung (36) bei durch den Takt synchronisierten Zeiten nach der vorbestimmten Phase der Netzwechselspannung zu bestimmen.

6. Das System nach Anspruch 5, wobei die Taktgebervorrichtung (36) ein Taktpulssignal an dem synchronen Umwandler (34) bei einer Frequenz von F/4 schafft, so daß die maximale Frequenzausgabe des synchronen Umwandlers F/8 ist und das dazwischenkommende Intervall zwischen dem Ende des vorhergegangenen Intervalls und dem Beginn eines neuen Umwandlungsintervalls zu einer vielfachen Frequenz der Taktgebervorrichtung (36) so synchronisiert ist, daß die Ausgabepulse von der Umwandlungsvorrichtung (34) außerhalb des dazwischenkommenden Intervalls erzeugt werden.

7. Das System nach Anspruch 5, wobei die Zeitschaltkreisvorrichtung einen Einzelpuls-Netzsynchronisationsschaltkreis (54) umfaßt, der die Taktpulssignale von der Taktgebervorrichtung (36) bei einer Frequenz empfangen kann, die ein Vielfaches der maximalen Ausgabefrequenz des synchronen Spannung-zu-Frequenz-Umwandlers (34) ist, und der ein Netzwechselspannungssynchronisationssignal empfangen kann, wobei der Einzelpuls-Netzsynchronisationssationsschaltkreis (54) nach dem Empfang eines ersten Taktpulssignals nach dem Vorhandensein eines Netzwechselspannungssynchronisationssignals eine Einzelpulsausgabe aussenden kann; weiter umfassend einen Schieberegisterverzögerungsschaltkreis (62), der die Einzelpulsausgabe empfängt und in Antwort darauf eine Folge von mindestens zwei Pulsen jeweils zu dem Register (44) aussendet, um zu bewirken, daß das Register (44) den Zählwert in dem Zähler (42) einliest, um bei dem Zähler (42) zu bewirken, daß der Zähler (42) zurückgesetzt wird, um ein neues Umwandlungsintervall zu beginnen.

8. Das System nach Anspruch 7, wobei die Taktgebervorrichtung (36) Taktpulssignale in einem Vielfachen von einer vorbestimmten Frequenz F erzeugt, die Taktgebervorrichtung (36) Taktpulssignale an dem synchronen Umwandler (34) bei einer Frequenz F/4 so schafft, daß die maximale Ausgabefrequenz des synchronen Umwandlers (34) F/8 ist, und die von dem Einzelpuls-Netzsynchronisationsschaltkreis (54) von der Taktgebervorrichtung (36) empfangenen Taktpulssignale von einer Frequenz von F/2 sind.

9. Das System nach Anspruch 8, welches eine Quadrierlogikschaltkreisvorrichtung (58) umfaßt, die die Taktgebervorrichtung (36) mit der Einzelpuls-Netzsynchronisationsschaltkreisvorrichtung (54) verbindet, um Taktpulssignale an der Synchronisationsschaltkreisvorrichtung (54) bei einer Frequenz F/2 und um die Hälfte des Intervalls der Frequenzkurve F verzögert zu schaffen.

10. Das System nach Anspruch 5, wobei ein programmierbarer Verstärker (22) so angeordnet ist, daß er das analoge Eingangssignal vor dem Liefern des analogen Eingangssignals an den synchronen Spannung-zu-Frequenz-Umwandler (34) empfängt und verstärkt, eine Verstärkungsbereichsteuervorrichtung (28) des Verstärkers so angeordnet und betreibbar ist, daß sie die nachfolgenden in dem Register (44) gespeicherten Zahlen empfängt, und die so angeordnet ist, daß sie den programmierbaren Verstärker (22) steuert, wobei die Verstärkungsbereichsteuervorrichtung (28) des Verstärkers als Antwort auf den Nachweis einer Zahl von dem Register (44) so betrieben werden kann, daß sie anzeigt, daß der synchrone Spannung-zu-Frequenz-Umwandler (34) bei maximaler Frequenz läuft, um den Verstärkungsfaktor des programmierbaren Verstärkers (22) zu verringern, und wobei die Verstärkungsbereichssteuervorrichtung (28) des Verstärkers bei dem Nachweis einer Zahl niedriger als ein vorbestimmter minimaler Wert so betreibbar ist, daß sie den Verstärkungsfaktor des programmierbaren Verstärkers (22) erhöht, und die Verstärkungsbereichssteuervorrichtung (28) des Verstärkers Vorrichtungen (76) einschließt, die in der Lage sind, die Ausgabe aus dem Register (44) durch den Verstärkungsfaktor (44) zu dividieren, um ein genau ausgewogenes digitales Ausgabesignal zu schaffen.

11. Das System nach Anspruch 10, wobei der programmierbare Verstärker (22) so betreibbar ist, daß er den Verstärkungsfaktor in Antwort auf das Bereichssteuersignal über einen Bereich von einhundert zu eins in zwei Schritten von zehn zu eins verändert, und wobei die Verstärkungsbereichssteuervorrichtung (28) des Vertärkers ein Teil eines für allgemeine Zwecke geeigneten Computers (30) ist, welcher so programmiert ist, daß er die Verstärkungsbereichssteuerfunktion des Verstärkers erfüllt.

12. Das System nach Anspruch 1, das eine Überlastbegrenzungsschaltung (20) und einen Tiefpaßfilter (14, 16) zum Schutz des verbleibenden Systems von Überlastspannungsbedingungen umfaßt.

## Revendications

1. Système à spectrophotomètre ayant un spectrophotomètre (8) fournissant un signal analogique d'échantillonnage, des moyens d'amplification (12, 22) pour amplifier le signal analogique, et des moyens de conversion analogique-numérique pour convertir le signal analogique d'échantillonnage en un signal numérique de sortie, dans lequel les moyens de conversion analogique-numérique comprennent :
- un convertisseur synchrone de tension en fréquence (34) connecté de manière à recevoir la tension du signal d'entrée analogique et à générer un train d'impulsions de sortie;
- un compteur (42) connecté de manière à recevoir et à compter les impulsions de sortie dudit convertisseur synchrone de tension en fréquence (34);
- un registre numérique (44) connecté audit compteur (42) pour recevoir périodiquement et mémoriser le compte dans ledit compteur (42);
caractérisé en ce que lesdits moyens de conversion analogique-numérique comprennent de plus :
- des moyens à circuit de synchronisation de l'intervalle de conversion, connectés de manière à commander le fonctionnement dudit compteur (42) et dudit registre (44) pour déterminer un intervalle de conversion durant lequel les impulsions de sortie dudit convertisseur synchrone de tension en fréquence (34) sont accumulées dans ledit compteur (42) et ensuite mémorisées dans ledit registre (44);
- lesdits moyens à circuit de synchronisation de l'intervalle de conversion étant connectés et arrangés de manière à recevoir la tension du réseau alternatif, fonctionnant de manière à déterminer la fin d'un intervalle de conversion précédent et le début d'un nouvel intervalle de conversion en réponse à une phase prédéterminée d'un cycle prédéterminé de la tension du réseau alternatif, pour synchroniser exactement l'intervalle de conversion avec la fréquence du réseau alternatif; et
- lesdits moyens à circuit de synchronisation de l'intervalle de conversion étant configurés et connectés audit convertisseur synchrone de tension en fréquence (34) de façon à commander la génération des impulsions de sortie de telle sorte que les impulsions de sortie sont générées seulement durant un intervalle de conversion.

2. Système selon la revendication 1, dans lequel le cycle prédéterminé pour déterminer la fin d'un intervalle de conversion précédent et le début d'un nouvel intervalle de conversion correspond à chaque cycle.

3. Système selon la revendication 1, dans lequel le cycle prédéterminé pour déterminer la fin d'un intervalle de conversion précédent et le début d'un nouvel intervalle de conversion est séparé du cycle prédéterminé précédent par au moins deux intervalles de fréquence complets du réseau.

4. Système selon la revendication 1, comprenant :
- des moyens (30) pour recevoir et corriger le nombre dudit registre (44) comprenant :
- des moyens (80) pour la mesure exacte de la durée de chaque intervalle de conversion et
- des moyens (77) pour multiplier le nombre mémorisé dans ledit registre par une fonction qui est la réciproque de la mesure exacte de la durée provenant desdits moyens de mesure exacte (80), pour corriger le nombre par rapport aux variations de l'intervalle de conversion.

5. Système selon la revendication 1, dans lequel lesdits moyens à circuit de synchronisation comprennent des moyens d'horloge (36) connectés audit convertisseur synchrone (34) pour commander le fonctionnement dudit convertisseur synchrone (34), lesdits moyens à circuit de synchronisation fonctionnant de manière à déterminer la fin d'un intervalle de conversion précédent et le début d'un nouvel intervalle de conversion en synchronisme avec lesdits moyens d'horloge (36) à des temps synchronisés d'horloge après ladite phase prédéterminée de la tension du réseau alternatif.

6. Système selon la revendication 5, dans lequel lesdits moyens d'horloge (36) fournissent des signaux d'impulsions d'horloge audit convertisseur synchrone (34) à une fréquence F/4, de telle sorte que la fréquence de sortie maximale dudit convertisseur synchrone est F/8 et que l'intervalle intermédiaire entre la fin de l'intervalle de conversion précédent et le début d'un nouvel intervalle de conversion est synchronisé avec une fréquence multiple desdits moyens d'horloge (36) de telle manière que les impulsions de sortie desdits moyens de conversion (34) sont générées en dehors dudit intervalle intermédiaire.

7. Système selon la revendication 5, dans lequel lesdits moyens à circuit de synchronisation comprennent un circuit de synchronisation du réseau à impulsion unique (54) fonctionnant de manière à recevoir des signaux d'impulsions d'horloge provenant desdits moyens d'horloge (36) à une fréquence qui est un multiple de la fréquence de sortie maximale dudit convertisseur synchrone de tension en fréquence (34) et fonctionnant de manière à recevoir un signal de synchronisation du réseau alternatif, ledit circuit de synchronisation du réseau à impulsion unique (54) fonctionnant lors de la réception du premier signal d'impulsion d'horloge après la présence d'un signal de synchronisation du réseau alternatif pour fournir une impulsion de sortie unique; un circuit à retard à registre à décalage (62) étant connecté de manière à recevoir ladite impulsion de sortie unique et fonctionnant en réponse à celle-ci pour émettre une séquence d'au moins deux impulsions respectivement vers ledit registre (44), pour que ledit registre (44) lise le compte dans ledit compteur (42), et vers ledit compteur (42), pour remettre à zéro ledit compteur (42) pour commencer un nouvel intervalle de conversion.

8. Système selon la revendication 7, dans lequel lesdits moyens d'horloge (36) génèrent des signaux d'impulsions d'horloge multiples d'une fréquence prédéterminée F, lesdits moyens d'horloge (36) fournissant des signaux d'impulsions d'horloge audit convertisseur synchrone (34) à une fréquence F/4, de telle sorte que la fréquence de sortie maximale dudit convertisseur synchrone (34) est F/8, et lesdits signaux d'impulsions d'horloge reçus par ledit circuit de synchronisation du réseau à impulsion unique (54) provenant desdits moyens d'horloge (36) étant à une fréquence F/2.

9. Système selon la revendication 8, qui comprend des moyens à circuit logique en quadrature (58) interconnectant lesdits moyens d'horloge (36) et lesdits moyens à circuit de synchronisation du réseau à impulsion unique (54) pour fournir des signaux d'impulsions d'horloge auxdits moyens à circuit de synchronisation (54) à une fréquence F/2 et retardés de la moitié de l'intervalle de la courbe de fréquence F.

10. Système selon la revendication 5, dans lequel un amplificateur à gain programmable (22) est connecté de manière à recevoir et à amplifier le signal d'entrée analogique préalablement à la fourniture dudit signal d'entrée analogique audit convertisseur synchrone de tension en fréquence (34); des moyens de commande d'amplitude du gain de l'amplificateur (28) étant connectés et fonctionnant de manière à recevoir les nombres successifs mémorisés dans ledit registre (44), et étant connectés de manière à commander ledit amplificateur programmable (22), lesdits moyens de commande d'amplitude du gain de l'amplificateur (28) fonctionnant en réponse à la détection d'un nombre provenant dudit registre (44) indiquant que ledit convertisseur synchrone de tension en fréquence (34) fonctionne à une fréquence maximale de manière à réduire le degré d'amplification dudit amplificateur programmable (22), lesdits moyens de commande d'amplitude du gain de l'amplificateur (28) fonctionnant lors de la détection d'un nombre au-dessous d'une valeur minimale prédéterminée de manière à accroître le degré d'amplification dudit amplificateur programmable (22), et lesdits moyens de commande d'amplitude du gain de l'amplificateur (28) incluant des moyens (76) fonctionnant de manière à diviser la sortie dudit registre (44) par ledit degré d'amplification pour fournir un signal de sortie numérique échelonné précisément.

11. Système selon la revendication 10, dans lequel ledit amplificateur programmable (22) fonctionne de manière à changer le degré d'amplification en réponse à des signaux de commande d'amplitude du gain pour une amplitude de cent à un en deux étapes de dix à un, et dans lequel lesdits moyens de commande d'amplitude du gain de l'amplificateur (28) représentent une partie d'un calculateur universel (30) qui est programmé pour accomplir la fonction de commande d'amplitude du gain de l'amplificateur.

12. Système selon la revendication 1, qui comprend un circuit limiteur de charge (20) et un filtre passe-bas (14,16) pour protéger le reste du système des conditions de tension de surcharge.
